# EUROPEAN PATENT APPLICATION

(11) **EP 0 978 871 A2**
(43) Date of publication of application: **09.02.2000**
(21) Application number: 99114184.7
(22) Date of filing: 22.07.1999
(51) Int. Cl.: H01L 21/60, H01L 23/04

(54) **A low power packaging design**

(30) Priority: 05.08.1998 US 129321
(71) Applicant: HARRIS CORPORATION, Melbourne, Florida 32919 (US)
(72) Inventor: Hewitt, Charles, Melbourne, Florida 32919 (US)
(74) Representative: Fleuchaus, Leo, Dipl.-Ing.

(57) **Abstract**

A connector 20 has a strap 21 for a drain contact formed in a conventional sheet of leadframe metal. The sheet is punched and formed to a fashion bent edge tab contacts 22, 24 with a surface for mounting the power MOSFET. The bent edge tab contains 22, 24 bring the drain electrical current from the backside of a mounted device to the plane comprising the top side of the device 90.

## Description

This invention relates in to packages for semiconductor, and, in particular, to low electrical resistance packages for power semiconductor devices.

There is a surging demand for portable electronic equipment such as laptop computers, personal digital assistants, personal organizers and cellular telephones. The portability requirements of these end products results in market demands for ever smaller, lighter weight, less power consuming and less costly equipment designs. This in turn drives the semiconductor component technologies and designs to achieve ever smaller, lighter weight and less power dissipating packaging designs while requiring that this be achieved at lower component manufacturing costs.

By their very nature, portable electronic equipment products rely heavily on the use of battery power. In order to extend the useful life of the battery or, in the case of rechargeable batteries, to extend the operating time between battery rechargings, products have monitor circuits that put the product (or portions of it) into a quiescent state until the user activates the device to its full functional operation. Nevertheless, there is still an unmet and long felt need to find further methods and apparatus for extending the life of the battery power supply of portable electronic equipment.

A major factor in determining useful battery life is the amount of power consumed by the power semiconductor components used in the portable electronic products. These power semiconductors are used to condition the DC voltages and currents supplied by the batteries to the various electronic circuits of the products. They are also used to turn the electrical power on and off to various circuits depending on the demand for their operation. In both of these applications, the DC current produced by the batteries must flow through the controlling power semiconductor components when they are in the power-on state. To the extent that those components have any electrical resistance, even in the power-on state they dissipate some of the limited battery power by generating unproductive heat when conducting current. One way of reducing this power loss is to reduce the resistance of the power component when it is in the power-on state. Both the semiconductor device and its packaging contribute to the semiconductor components electrical resistance. Much has been accomplished in recent years to substantially reduce the resistance of the power semiconductor device when it operates in the power-on state. However, the demand for smaller and smaller packages for these devices when used in portable equipment has caused the electrical resistance contribution of the package used to house the semiconductor device to increase. Still, OEM manufacturers demand significant reductions in power semiconductor components' wasteful power-on resistance while also demanding that they be supplied in smaller packages at lower costs.

The present invention includes a MOSFET comprising a semiconductor substrate comprising first and second planar surfaces, in the first surface a source region and a channel region, an insulating layer over the channel region, in the second surface a drain region extending substantially over the second surface, on the second surface a drain contact that substantially covers the drain region.

The invention also includes a method for flip chip mounting a semiconductor device comprising providing a MOSFET with a source and gate contact on a first surface and drain contact on a second surface, attaching with solder or conductive epoxy, etc. the drain contact of the MOSFET with a drain connector comprising a conductive material that substantially covers the drain area of the MOSFET substrate and has one or more tabs extending over at least one edge of the substrate and whose bottom surface is substantially coplanar with the MOSFET gate and source interconnection pads or bumps to effect planar contact to the printed circuit board, mounting the MOSFET on the printed circuit board with the first surface facing and contacting the printed circuit board and the tab(s) contacting the printed circuit board, soldering the source and gate contacts and the drain connector to the printed circuit board.

The invention provides a new packaging design for power semiconductor components that significantly reduces the package's contribution to the overall component's electrical resistance and thereby dramatically reduces its power loss in the on state. The invention simultaneously achieves lower power-on resistance, smaller package size and lower component packaging material and assembly costs. It is also compatible with conventional PCB assembly equipment and processes used to produce portable electronic products.

The invention is known under the trade name of StrapPak package. It comprises a metal connector strap to which a power semiconductor device having both top and bottom side electrical contacts is mechanically and electrically attached. The StrapPak package houses a power semiconductor device such as a power MOSFET, IGBT, thyristor, power bipolar transistor, diode, etc. A common feature in such devices is their requirement to have an electrical connection to both the top side and the back side of the semiconductor device. For example, power MOSFET devices are typically designed and produced such that the backside of the device serves as the electrical drain contact for the device. In conventional power packages, the backside of the MOSFET device (or other power semiconductor device type) would be mechanically bonded to a metal tab using an electrically conductive bonding material and this tab would be an integral part of an external package lead. The semiconductor device's topside electrical contacts is wire bonded to other package leads and the whole assembly is then overmolded to encapsulate the die, wires and leads. In contrast, with the StrapPak invention, the die is mounted to a metal strap that serves as the semiconductor device's backside electrical connection and the topside electrical connections are made using flip chip interconnect technology. The metal strap is designed to give mechanical protection to the device such that it can be handled in conventional printed circuit board (PCB) surface mount assembly processing without damaging the fragile silicon device.

The invention has a strap for the drain contacts. The strap is formed in a conventional sheet of leadframe metal. The sheet is punched and formed to fashion contacts with a surface for mounting the power MOSFET. Bent edge tabs bring the drain electrical current from the backside of the MOSFET to the plane comprising the top side of the MOSFET device. In this manner, all electrical contacts for the finished component are brought into the same plane to enable surface mount assembly to printed circuit boards. The top of the power MOSFET has source and drain contacts that are fabricated at the wafer level for flip chip interconnect assembly directly to the PCB. The MOSFET semiconductor device gate and source metal contacts can be resized at the level of the top passivation layer to make them more robust for assembly direct to the PCB. For example, in the case of using solder flip chip interconnect, after the top layer overcoat or passivation layer is put onto the silicon device, a smaller opening can be made in this passivation layer than the original source metal pattern below it and it can be spaced further from the gate pad so that its edge and that of the gate metal pad are fare enough apart to reduce the possibility of forming solder bridges between the gate and source connection to the PCB.

The StrapPak leadframe is used to mechanically move the StrapPak packages from one component manufacturing step to the next. In a typical production flow, the StrapPak leadframe is fed into an automated machine that assembles the individual semiconductor devices to the StrapPak. The device is mounted to the StrapPak connectors using solder or epoxy die attach material and processes in one stage and then indexed into the next stage of assembly. The mounted device is branded with information placed on the surface of the StrapPak connector opposite the surface on which the semiconductor device is mounted to in order to identify the type of device, its manufacturing lot number, etc. The devices are electrically tested either in leadframe format or after individual singulation from the leadframe. The individual StrapPak components are singulated from the leadframe by shearing the tie bars that extend from the side edges of the StrapPak connectors to the bulk leadframe. The electrically good, singulated devices are stored in plastic tubes or in conventional pocket tape and reel packing until final assembly on a printed circuit board. During PCB assembly the devices are picked from the tube or the pocket tape and place on the printed circuit board where they are permanently soldered.

The invention will now be described, by way of example, with reference to the accompanying drawings in which:
Figure 1 is a planar view of a metal sheet leadframe with indexing and alignment holes in which the StrapPak drain connectors are formed;
Figure 2 is an expanded view of a portion of the metal sheet showing a drain connector formed in the sheet;
Figure 3 is a side (or in-plane) view of the drain connector of Figure 1;
Figure 4 is a top view of the StrapPak package branded or marked with indicia;
Figure 5 is side view of the StrapPak package with mounted device;
Figure 6 is a bottom view of the StrapPak package with mounted device;
Figure 7 is a cross-sectional view of a power MOSFET device;
Figure 8 is a plan view of a device attached to a connector and mounted on a printed circuit board; and
Figure 9 is a side view of the assembly of Figure 9.

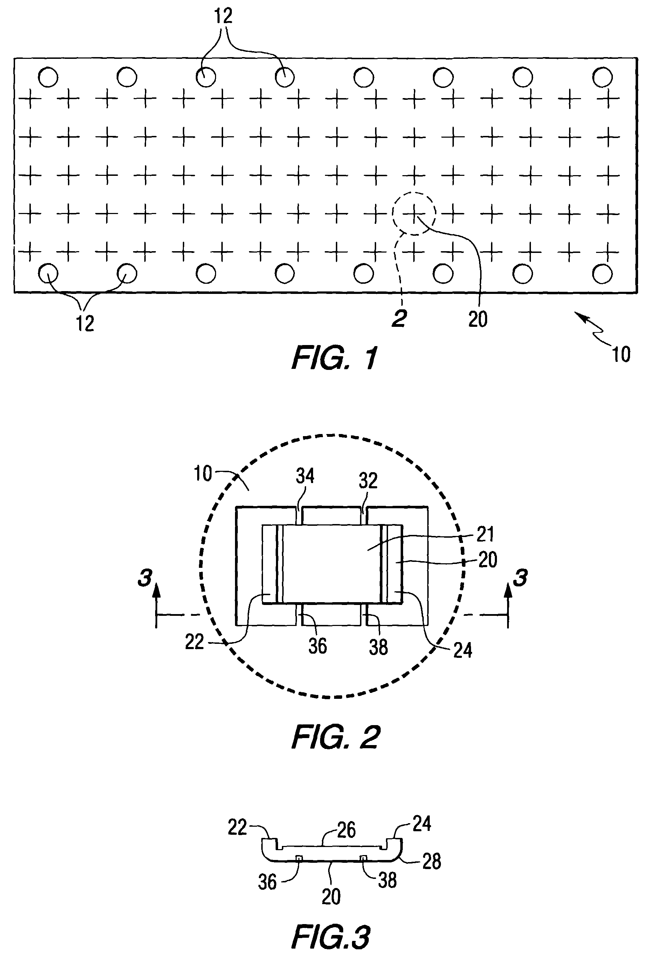

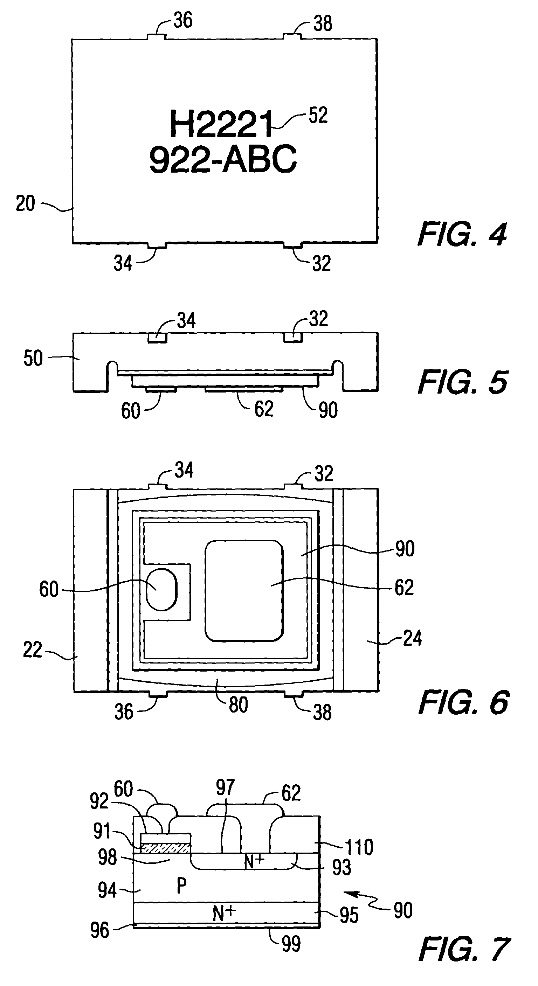

Figures 1-3 show the method for making the StrapPak drain connector 20 of Figures 4-6. The process begins with a step of stamping a metal sheet to form the StrapPak leadframe. Turning to Figure 1, the StrapPak stamped leadframe 10 is shown with index holes 12. The holes 12 receive travel pins (not shown) that advance the sheet 10 in a stamping machine (not shown) to form the leadframe and these holes are also used to index the leadframes through automated equipment in the semiconductor device to StrapPak assembly operations. The metal of leadframe 10 is any conventional semiconductor device packaging leadframe metal and the stamping machine is any conventional leadframe stamping machine equipped with a suitable die for forming drain connectors 20 as shown in Figures 2 and 3. In Figure 2, the connector 20 has tie bars 32, 34, 36, 38 that hold the StrapPak drain connector to the sheet. During the stamping operation opposite edges 22, 24 of the connector are bent with a forming radius 28 in a direction transverse to the surface 26 of the connector. In an alternate embodiment, the tie bars may be continuous strips of metal that are bent upwards in a direction similar to edges 22 and 24 upon severing from the leadframe in order to fully enclose the sidewalls of the device 20.

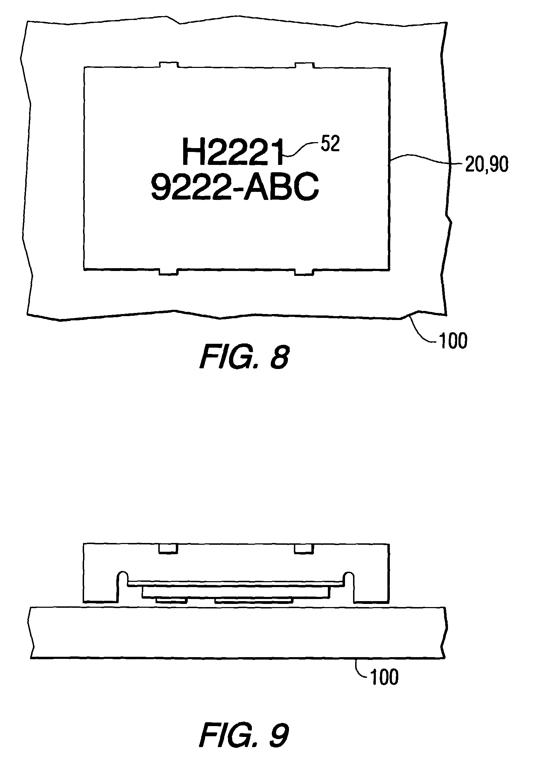

The connector 20 has a strap 21 for the drain contact formed in a conventional sheet of leadframe metal. The sheet is punched and formed to fashion contacts 22, 24 with a surface for mounting the power MOSFET. The bent edge tab contacts 22, 24 bring the drain electrical current from the backside of a mounted device to the plane comprising the top side of the device 90. In this manner, all electrical contacts for the finished component are brought into the same plane to enable surface mount assembly to printed circuit boards. For example, the top of the power MOSFET 90 (Figures 5, 7) has source, gate and drain contacts 60, 62 and 96 that are fabricated at the wafer level for flip chip interconnect assembly directly to a PCB 100. See Figures 8, 9. The MOSFET drain contact 96 is fabricated at the wafer level on the backside 99 (the side of the wafer opposite the source and gate contacts). When the MOSFET device 90 is mechanically and electrically connected to the StrapPak connector 20 using solder or electrically conductive epoxy, the drain metal contact layer 96 is electrically connected to the surfaces 22 and 24 of the StrapPak connector 20 which are in the same plane as the source and gate contacts 60 and 62 for surface mounting to a PCB. The MOSFET semiconductor device gate and source metal contacts can be resized at the level of the top passivation layer to make them more robust for assembly direct to the PCB 100.

Semiconductor devices, in particular power MOSFETs, are attached to the connectors 20 while the connectors are still held in the leadframe 10. The leadframe 10 with the formed connectors 20 is advanced through a conventional die attach station where a power MOSFET is mechanically and electrically attached to each connector. A typical power MOSFET 90 is shown in Figure 7. It has a first surface 97 with an N+ source region 93, a P body region 94 and a drain region 95. The drain region 95 extends across the bottom of the power MOSFET. A drain contact metal layer 96 on the second surface enables low ohmic contact with the drain region 95. An insulating layer 91 and a conductive gate 92 cover a channel region 98. The MOSFET 90 has its drain contact 96 mechanically and electrically connected to the surface 26 of the StrapPak drain connector 20. Solder or other suitable interconnect material pads or bumps 60, 62 are formed on the gate and source metal areas as defined by openings in the top passivation or overcoat layer 110. These bumps together with the drain connector 20 eliminate all wire bonding to the device 90. Because all of the input and output connectors to the device have relatively large areas and the source bump is thicker than the underlying source metal pattern, the power loss due to connector resistance is dramatically reduced as compared to using just the conventional, thinner source metal pattern and wire bond connections to package leads.

The present invention is useful in devices that have a common contact across an entire surface but it may also be used to offer mechanical protection and automated assembly handling of other semiconductor devices as well. Any device that has a common backside contact may be substituted for the MOSFET 90 and achieve front side surface mounting capability. For example, insulated gate bipolar transistors (IGBT) has a common anode structure across one surface and the StrapPak package design concept may be used to connect to the anode and bring its interconnect to the PCB to the same plane as the IGBT device's top side contacts for surface mounting . In a similar manner, other discrete devices including power bipolar transistors, thyristors, or an integrated circuit with a common backside contact for all devices may be packaged using the StrapPak design concept.

After the devices 90 are mounted on the connectors 20, the back side of the connectors are branded with suitable identifying information. As an example, the indicia 52 (Figures 4, 8) includes information about the type of device and the manufacturing lot. The indicia are made with conventional printing or laser ablation apparatus. In the case of discrete power semiconductor devices, electrical testing may be done on individual devices while assembled in the StrapPak connectors 20 and still attached to the leadframe 10. In the case of MOSFET devices, any electrical contact to the leadframe could be correlated to serve as the connection between the tester and the device under test drain connection. The individual device's gate and source contacts to the tester are made using electrical probes and the contact resistance is reduced due to the large and thick source and gate pads or bumps 60, 62. Next the individual StrapPak assembled devices 20 are from the leadframe 10. The leadframe 10 with mounted devices 90 is advanced to a conventional singulation station. At the singulation station the tie bars 32, 34, 36, 38 are severed from the StrapPak connector 20. The singulated MOSFET StrapPak devices (Figures 5,6) are then automatically picked up and put into conventional tape and reel storage packing (not shown). The conventional tape has depressed cavities or pockets into which the StrapPak is placed with the semiconductor die surface face down and the metal connector surface facing up for ease of handling at PCB assembly. A cover tape is then adhered over the pocket tape to enclose or trap the finished StrapPak assembled devices for storage and shipment.

The devices in the tape and reel format 108 are shipped to a user, such a manufacture of computers or cellular telephones. The reel is unraveled on another conventional pick and place machine which removes the devices from the tape and places them on solder paste paterns on a PCB 100 as shown in Figures 8, 9. Once on the PCB 100, the devices 20,90 are soldered in a surface mount PCB assembly process well known to those skilled in the art. This solder reflow surface mount process mechanically and electrically connects the StrapPak drain contacts 22, 24, gate contact 60 and source contact 62 to its intended metal circuit traces on the PCB 100 as shown in Figure 9.

A connector 20 has a strap 21 for a drain contact formed in a conventional sheet of leadframe metal. The sheet is punched and formed to a fashion bent edge tab contacts 22, 24 with a surface for mounting the power MOSFET. The bent edge tab contains 22, 24 bring the drain electrical current from the backside of a mounted device to the plane comprising the top side of the device 90.

## Claims

1. A MOSFET comprising a semiconductor substrate comprising first and second planar surfaces, in the first surface a source region and a channel region, an insulating layer over the channel region, in the second surface a drain region extending substantially over the second surface, on the second surface a drain contact that substantially covers the drain region.

2. A MOSFET as claimed in claim 1 wherein the drain contact comprises a shaped metal contact including a planar portion of substantially the same size as the second surface, and at least one tab extending from one edge of the drain contact in a direction toward the plane of the first surface, in which the tabs or tab extends to a level substantially coplanar with the first surface of the substrate.

3. A MOSFET as claimed in claim 2 wherein the second surface drain contact comprises a planar portion of substantially the same size as the second surface and has a pair of tabs extending along the length of opposite edges in a direction toward the plane of the first surface.

4. A MOSFET as claimed in claim 3 wherein the second surface contact comprises a quadrilateral unitary coined metal connector with a planar portion having two tabs on opposite edges extending beyond the second surface and bent in a direction toward the plane of the first surface, and preferably the metal connector is coated with solder or preplated with a solderable metal finish.

5. A method for flip chip mounting a semiconductor device comprising providing a MOSFET with a source and gate contact on a first surface and drain contact on a second surface, attaching with solder or conductive epoxy, etc. the drain contact of the MOSFET with a drain connector comprising a conductive material that substantially covers the drain area of the MOSFET substrate and has one or more tabs extending over at least one edge of the substrate and whose bottom surface is substantially coplanar with the MOSFET gate and source interconnection pads or bumps to effect planar contact to the printed circuit board, mounting the MOSFET on the printed circuit board with the first surface facing and contacting the printed circuit board and the tab(s) contacting the printed circuit board, soldering the source and gate contacts and the drain connector to the printed circuit board.

6. A method as claimed in claim 5 including forming the drain connector by stamping a coined metal sheet into a leadframe containing multiple drain connectors, and the further step of printing indicia on the exposed surface of the drain connector.

7. A method for simultaneously mounting drain connectors on a plurality of MOSFETs comprising the steps of stamping a metal sheet to provide a plurality of drain connectors, each connector comprising a rectangular planar surface with a first pair of opposite edges bent into tabs and extending in a direction transverse to the planar surface and a second pair of edges comprising tie bars for holding the connectors to the metal sheet, mounting a MOSFET on each drain connector, and separating the mounted MOSFETs from the metal sheet by severing the tie bars from the metal sheet.

8. A method as claimed in claim 7 wherein the step of mounting the MOSFETs includes mechanically and electrically connecting a surface of each MOSFET with a drain contact to the surface of one of the drain connectors, including the step of stamping includes bending the first edges of the drain connector to extend in the transverse direction a distance to about the thickness of the MOSFET.
